# EUROPEAN PATENT APPLICATION

(11) **EP 1 993 336 A2**
(43) Date of publication of application: **19.11.2008**
(21) Application number: 08156348.8
(22) Date of filing: 16.05.2008
(51) Int. Cl.: H05K 7/14, H05K 9/00

(54) **Chassis base assembly and display device including the same**

(30) Priority: 18.05.2007 KR 20070048909
(71) Applicant: Samsung SDI Co., Ltd., Suwon-si, Gyeonggi-do 442-390 (KR)
(72) Inventor: Yeo, Jae-Young c/o Legal & IP Team Samsung SDI Co., Ltd., Suwon-si Gyeonggi-do (KR); Pyo, Kyung-Rae c/o Legal & IP Team Samsung SDI Co., Ltd., Suwon-si Gyeonggi-do (KR)
(74) Representative: Walaski, Jan Filip

(57) **Abstract**

A display device includes a panel assembly and a chassis base attached to the panel assembly. A circuit board include a plurality of circuit elements is attached to the chassis base to form a space between the circuit board and the chassis base. A shield case for covering the circuit board and the space is located between the chassis base and the circuit board.

## Description

The present invention relates to a display device, and more particularly, to a chassis base assembly for a display device.

In general, flat display apparatus can be classified into an emissive type or a non-emissive type. Examples of emissive types include a flat cathode ray tube, a plasma display panel (PDP), a field emission display, and a light emitting diode. Examples of non- emissive types include a liquid crystal display.

The PDP is a display device that displays desired numbers, letters, and images, as would be understood by one of ordinary skill in the art. A PDP includes a panel assembly, a filter assembly in front of the panel assembly, a chassis base assembly behind the panel assembly, and a case containing the panel assembly, the filter assembly, and the chassis base assembly. The chassis base assembly includes a chassis base, a plurality of circuit boards combined with the chassis base, and a plurality of circuit elements mounted on the circuit boards.

In some cases, the chassis base assembly serves to protect the panel assembly and the circuit boards from heat and also serves as an electrical ground and to shield against electromagnetic interference (EMI) noise.

An aspect of an embodiment of the present invention is directed toward the chassis base assembly having an improved structure for shielding against electromagnetic interference (EMI) noise by covering a circuit board on which circuit elements are mounted, and a display device including the chassis base assembly.

In an embodiment of the present invention, a display device includes a panel assembly and a chassis base attached to the panel assembly. A circuit board including a plurality of circuit elements is attached to the chassis base to form a space between the circuit board and the chassis base. A shield case for covering the circuit board and the space is located between the chassis base and the circuit board.

In one exemplary embodiment, the shield case surrounds the circuit board and covers the plurality of circuit elements. The shield case may include a ceiling and a sidewall extending towards the chassis base from the ceiling. The shield case may include a generally hollow rectangular configuration having an open end. In one exemplary embodiment, a flange extends from a bottom edge of the sidewall, the flange attachable to the chassis base by a fastener. Additionally, the sidewall may include a tab in a groove, the tab extending toward the circuit board and attached to the circuit board by a fastener. Further, the ceiling may include a plurality of heat radiation holes.

In one exemplary embodiment, the shield case includes a first shield case on the circuit board and a second shield case between the chassis base and the circuit board. The first shield case may include a ceiling for covering the plurality of circuit elements and a sidewall extending towards the chassis base from the ceiling, and the second shield case may include a sidewall surrounding the space between the chassis base and the circuit board. The second shield case may alternatively include a bottom unit contacting the chassis base and a sidewall extending toward the circuit board from the bottom unit to enclose the space between the chassis base and the circuit board. In one exemplary embodiment, the first shield case and the second shield case are fastened together with the circuit board therebetween. An EMI sponge may be located between the chassis base and the second shield case.

The accompanying drawings, together with the specification, illustrate exemplary embodiments of the present invention, and, together with the description, serve to explain the principles of the present invention.
FIG. 1 is an exploded perspective schematic of a display device according to an exemplary embodiment of the present invention.
FIG. 2 is a block diagram of a circuit board of the display device FIG. 1.
FIG. 3 is an exploded perspective schematic of a shield case mounted on a chassis base of the display device of FIG. 1.
FIG. 4 is a perspective cutaway schematic of a shield case according to a first exemplary embodiment of the present invention.
FIG. 5 is a cross-sectional schematic of the shield case of FIG. 4.
FIG. 6 is a cross-sectional schematic of a second exemplary embodiment of a shield case of the present invention.
FIG. 7 is a cross-sectional schematic of a third exemplary embodiment of a shield case of the present invention.
FIG. 8 is a cross-sectional schematic of a fourth exemplary embodiment of a shield case of the present invention.
FIG. 9 is a cross-sectional schematic of a fifth exemplary embodiment of a shield case of the present invention.
FIG. 10 is a perspective schematic of a sixth exemplary embodiment of a shield case of the present invention.
FIG. 11 is a cross-sectional schematic of the shield case of FIG. 10.
FIG. 12 is a cross-sectional schematic of a seventh exemplary embodiment of a shield case of the present invention.
FIG. 13 is a perspective schematic of an eighth exemplary embodiment of a shield case of the present invention.
FIG. 14 is a graph illustrating characteristics of EMI noise with respect to a conventional shield case.
FIG. 15 is a graph illustrating characteristics of EMI noise with respect to the first exemplary shield case of the present invention.
FIG. 16 is a graph illustrating characteristics of EMI noise on a general power supply board.
FIG. 17 is a graph illustrating characteristics of EMI noise with respect to the sixth exemplary shield case of the present invention installed on a power supply board.

In the following detailed description, only certain exemplary embodiments of the present invention are shown and described, by way of illustration. As those skilled in the art will recognize, the invention may be embodied in many different forms and should not be construed as being limited to the embodiments set forth herein. Like reference numerals designate like elements throughout the specification.

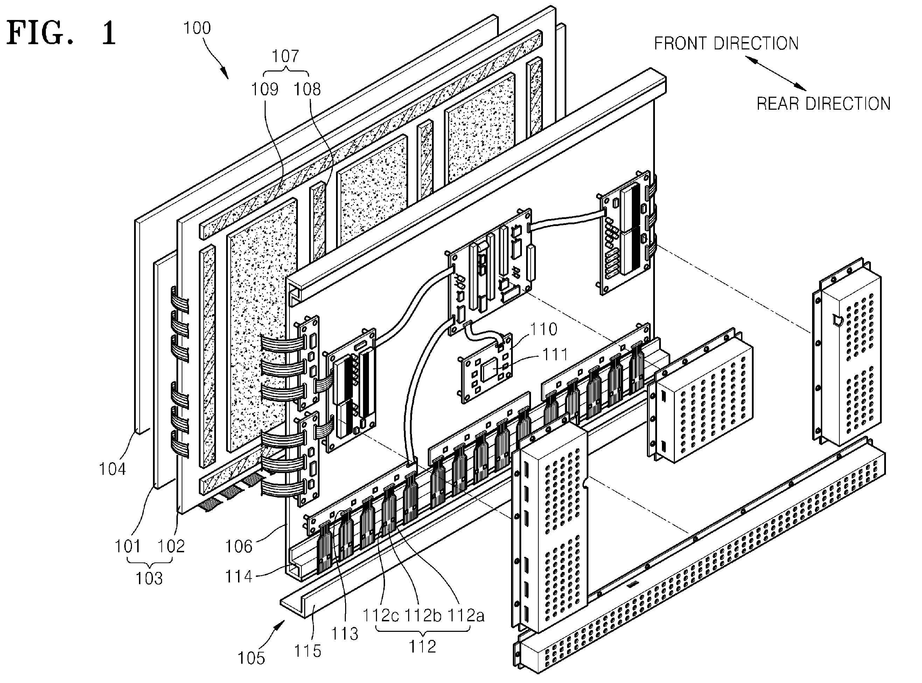

With reference now to FIG. 1, a PDP 100 according to an exemplary embodiment of the present invention is illustrated. The PDP 100 includes a panel assembly 103 including a first substrate 101 and a second substrate 102 coupled to (or attached to) the first substrate 101. A sealant is coated at an edge portion of the inner surface facing the first substrate 101 and the second substrate 102 so that a sealed inner space is formed.

When the panel assembly 103 is an AC type panel, the panel assembly 103 includes a plurality of pairs of discharge electrodes between the first substrate 101 and the second substrate 102, a dielectric layer covering the pairs of discharge electrodes, partition walls for dividing discharge cells, and red, green, and blue phosphor layers coated in the discharge cells.

A filter assembly 104 is attached (or directly attached) to a front surface of the panel assembly 103 to block electromagnetic waves generated from the panel assembly 103, to filter neon glow and to prevent (or reduce) reflection of external light. The filter assembly 104 includes a number of stacked films. For example, the filter assembly 104 may include a reflection preventing film on which an anti-reflection (AR) treatment is performed so as to prevent a decrease in visibility due to the reflection of external light, an electromagnetic wave shielding filter to efficiently shield electromagnetic waves generated during an operation of the panel assembly 103, and a wavelength selective absorption film to filter neon glow of about 590 nanometers. In addition, the filter assembly 104 can further include films having various other suitable functions.

A chassis base assembly 105 is attached to the back of the panel assembly 103 adjacent the second substrate 102 by a fastener 107. In one exemplary embodiment, the fastener 107 is in the center of the rear surface of the second substrate 102 and includes a heat conducting sheet 108 and a double-sided adhesive tape 109, wherein the heat conducting sheet 108 transmits heat generated from the panel assembly 103 during operation to the chassis base 106. The double-sided adhesive tape 109 is attached to a rear region of the second substrate 102 to which the heat conducting sheet 108 is not attached. Alternatively, the chassis base 106 is spaced from the second substrate 102 to form an air gap creating an air flow space between the chassis base 106 and the second substrate 102.

Chassis reinforcement members 114 are attached along a length of the upper and lower ends of the rear surface of the chassis base 106 to strengthen the chassis base 106. A cover plate 115 is configured to cover a lower length of the back of the chassis base 106, and is attached to the chassis base 106 and/or the chassis reinforcement members 114. In one embodiment as shown, the cover plate 115 is bent at least once to cover the lower end of the chassis base 106 and is attached to the chassis base 106 or the chassis reinforcement members 114. A plurality of circuit boards 110 are mounted on the rear surface of the chassis base 106. The circuit boards 110 include various circuit elements 111. Signal transmission units 112 such as flexible printed cables (FPC) are installed between the circuit board and the panel assembly 103. One end of the signal transmission unit 112 is connected to each electrode terminal in the panel assembly 103, and the other end of the signal transmission unit 112 is connected to a connector 113 electrically connected to the circuit element 111.

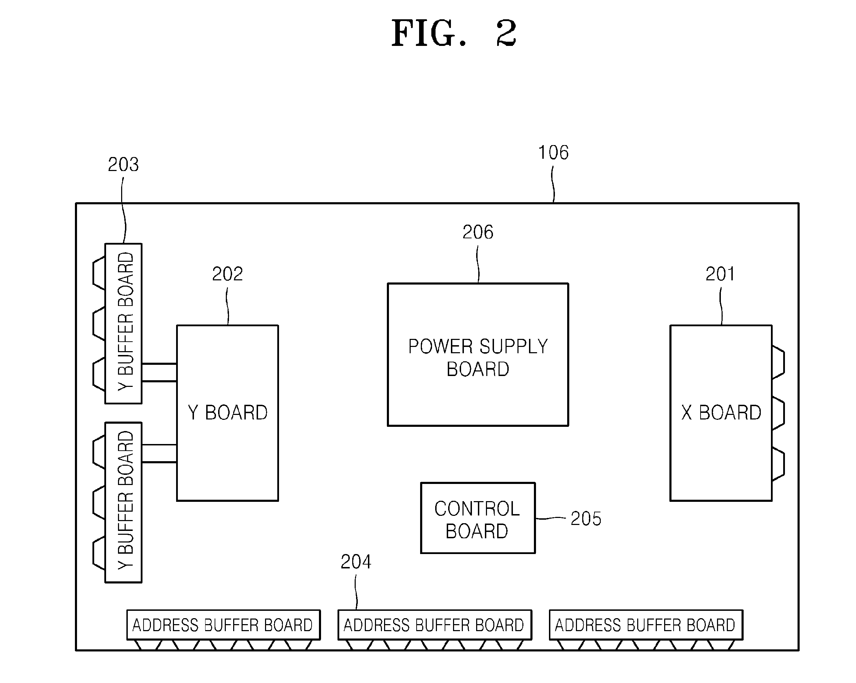

Each signal transmission unit 112 includes a plurality of driver integrated circuits (ICs) 112a, a plurality of wiring members 112b electrically connected to the operating ICs 112a, and a flexible film 112c that covers the wiring members 112b. As illustrated in FIG. 2, the circuit board 110 includes an X board 201, a Y board 202, a Y buffer board 203, an address buffer board 204, a control board 205, and a power supply board 206. The X board 201 controls operation of an X electrode of the panel assembly 103 (FIG. 1), the Y board 202 controls operation of a Y electrode of the panel assembly 103, the Y buffer board 203 controls operation of the Y electrode of the Y board 202, the address buffer board 204 controls operation of an address electrode of the panel assembly 103, and the control board 205 generates a control signal required to operate the X board 201, the address buffer board 204, and the control board 205.

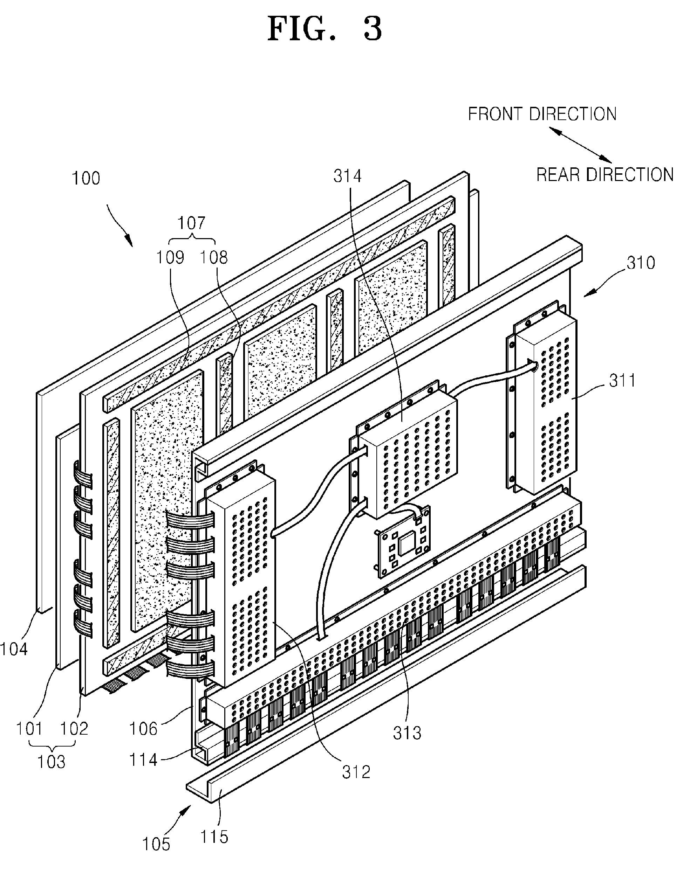

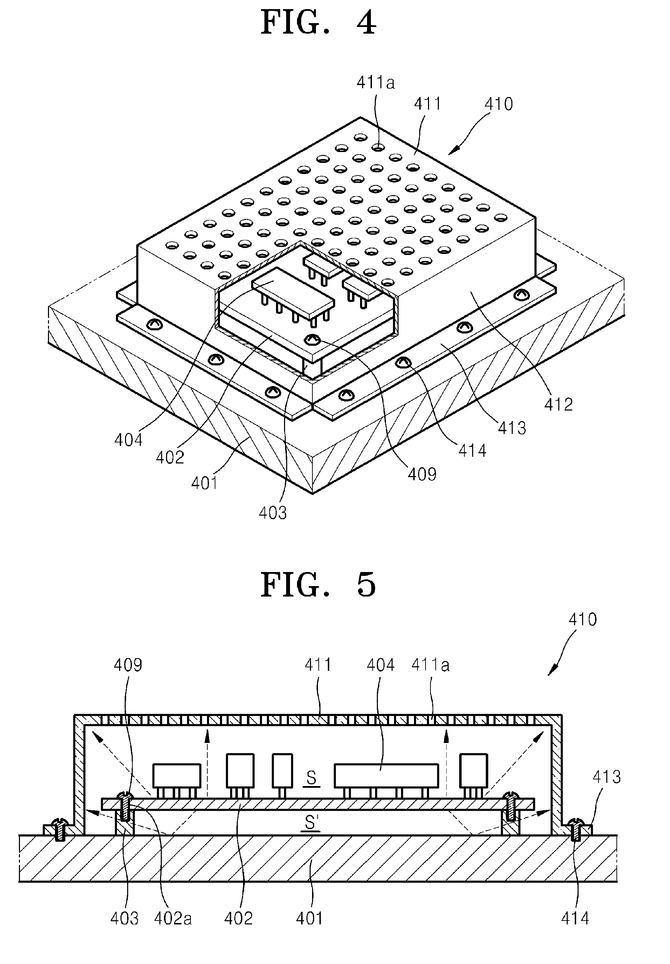

In at least one of the circuit boards 110, a plurality of shield cases 310 are provided to shield EMI noise, as illustrated in FIG. 3. In one exemplary embodiment, a first shield case 311 shields the X board 201 (FIG. 2), a second shield case 312 shields the Y board and the Y buffer board 203, a third shield case 313 shields the address buffer board 204, and a fourth shield case 314 shields the power supply board 206. Referring to FIGS. 4 and 5, a circuit board 402 is spaced from and arranged in parallel with a chassis base 401 by bosses 403 attached to the chassis base 401 by, for example, a screw 409 inserted into a boss hole 402a in the circuit board 402 at corner portions of the circuit board 402. A plurality of circuit elements 404 are mounted on the circuit board 402, and they may be mounted on a surface facing toward or away from (FIG. 4) the chassis base 401.

The circuit board 402 on which the circuit elements 404 are mounted is shielded from the outside environment by the shield case 410. The shield case 410 includes a ceiling 411, sidewalls 412 extending downward from the ceiling, and a flange 413 extending outward from a base of the sidewall 412. The shape of the ceiling 411 substantially corresponds to a shape of the circuit board 402, but may also be larger or smaller than the size of the circuit board 402.

The ceiling 411 is spaced from the circuit elements 404 so as to avoid contact with the circuit elements 404. The ceiling 411 may include a plurality of heat radiation holes 411a to allow heat generated from the circuit elements 404 to be emitted from the shield case 410. In one exemplary embodiment, a diameter of the heat radiation hole 411a is smaller than the permissible level for EMI noise radiated from the circuit elements 404 to penetrate and larger than the suitable (or minimum) value for heat generated from the circuit elements 404 to smoothly radiate through. The flange 413 is attached to the chassis base 401 by, for example, a rivet 414. However, the flange 413 may also be attached by, for example, screws, laser welding, welding, clip combining, and insert combining, among others.

A first space S and a second space S' are formed within the shield case 410 above and beneath the circuit board 402 and the circuit elements 404, respectively, to encompass the entire circuit board and circuit elements. In the shield case 410 according to the current embodiment of the present invention, the sidewall 412 is extended downwards from the edge of the ceiling 411 to form a hollow rectangular solid. However, the shield case 410 is not limited thereto, and can be any configuration having a space sufficient to accommodate the circuit board 402 and the circuit elements 404 therein.

The shield case 410 may be manufactured by, for example, a deep drawing process. Also, the shield case 410 may be a metal plate such as a galvanized steel plate to shield against EMI noise.

In such a shield case 410, the circuit board 402 on which the circuit elements 404 are mounted can be accommodated in the first and second spaces S and S' formed by combining the ceiling member 411 and the sidewall member 412. Accordingly, the shield case 410 can accommodate the entire circuit board 402.

Here, the flange member 413 contacts the outside surface of the chassis base 401 and is combined with a rivet 414 to fix the shield case 410 to the outside surface of the chassis base 401. In addition to this, screwing, laser welding, welding, clip combining, and insert combining can be used.
Accordingly, the first space S formed on the circuit board 402 on which the circuit elements 404 are mounted and the second space S' formed between the circuit board 402 and the chassis base 401 can be accommodated by the shield case 410. Meanwhile, when the shield case 410 includes the first and second spaces S, S' to accommodate the circuit board 402 on which the circuit elements 404 are mounted and thus covers the circuit board 402, various embodiments can exist with respect to the shield case 410.

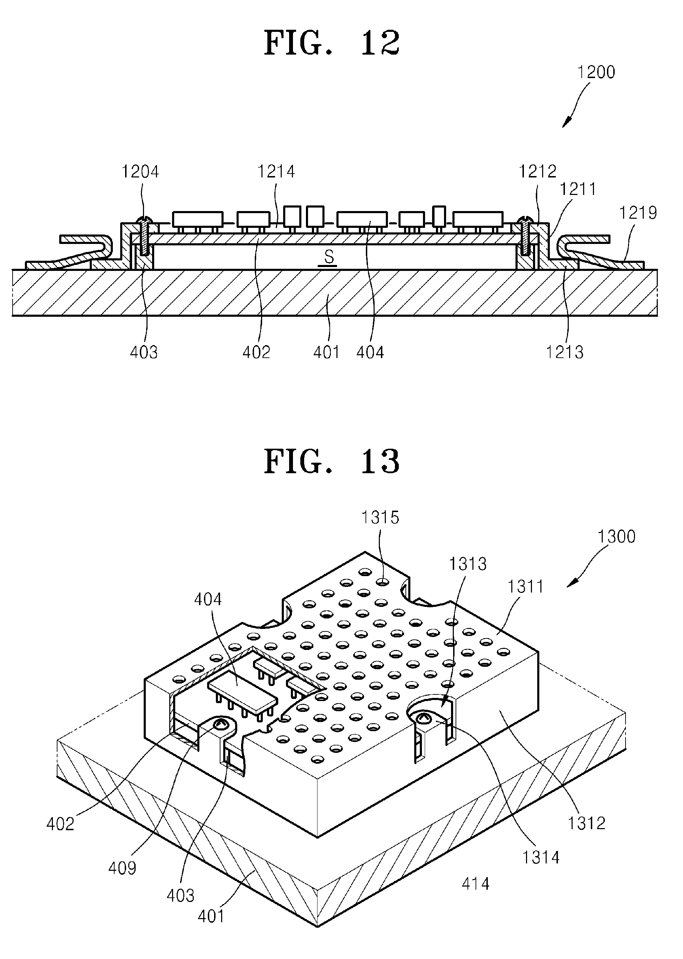

Alternatively, the shield case 410 may be attached to the circuit board 402 rather than to the chassis base 401. For example, referring to FIG. 13, a shield case 1300 includes a ceiling 1311 and a sidewall 1312, wherein the shield case 1300 is attached to the circuit board 402. A plurality of heat radiation holes 1315 are formed on the ceiling 1311.

A groove 1313 is formed in the sidewall 1312 and contains a tab 1314 extending toward the ceiling 1311 that is bent at least once. A plurality of grooves 1313 and tabs 1314 are located around a perimeter of the sidewall 1312. A portion of the tab 1314 contacts the surface of the circuit board 402 and screws 409 are inserted through the tab to connect the shield case 1300 to the circuit board.

Referring again to FIGS. 4 and 5, an operation of the shield case 410 is as follows. When EMI noise is radiated from the plurality of circuit elements 404 due to the operation of the panel, the EMI noise is reduced since the lower and upper portions of the circuit board 402 are shielded by the shield case 410. In addition, since the flange 413 contacts an exterior surface of the chassis base 401, induced current generated from the circuit elements 404 can be reduced. Also, heat generated from the circuit elements 404 can be rapidly emitted through the heat radiation holes 411a on the ceiling 411.

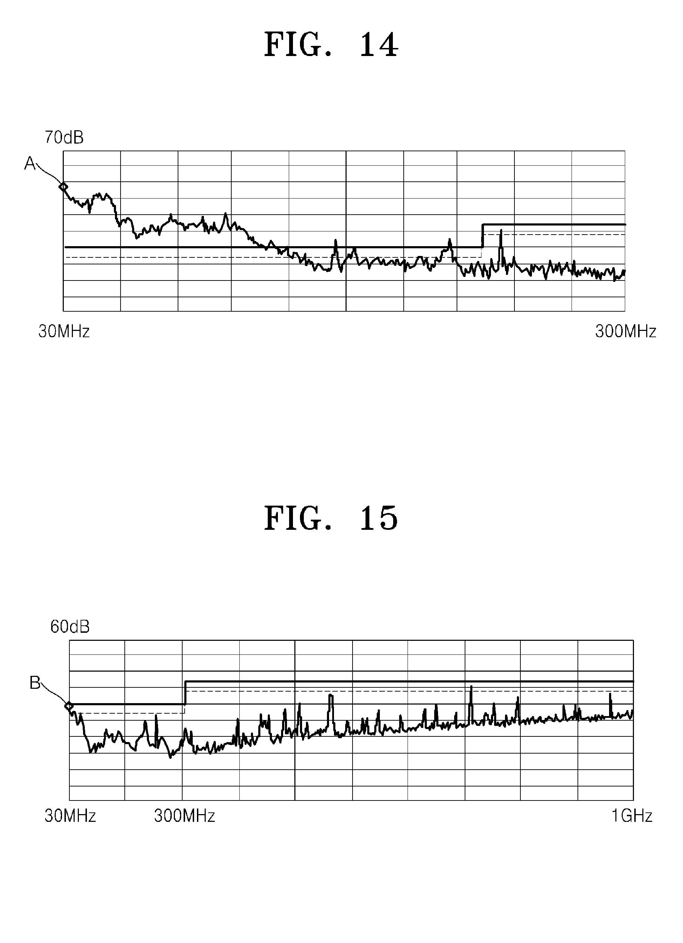

EMI noise as a result of a test is illustrated in FIGS. 14 and 15. As reflected in FIG. 14, only a space where the circuit elements are mounted on a circuit board (for example, the Y board) is shielded using a general shield case. As reflected in FIG. 15, a space where the circuit elements are mounted on a circuit board (for example, the Y board) and a space between the chassis base and the circuit board are shielded together with a shield case according to the first exemplary embodiment of the present invention.

With reference to FIGs. 14 and 15, the X-axis indicates a frequency in a range of 0-1 GHz and the Y-axis indicates a decibel range of 0-70 dB. In general, when the panel is used in public, a standard value in a frequency between 30 - 230 MHz is 40 dB and a standard value in a frequency between 230 - 1 GHz is 47 dB.

Referring to FIG. 14, when the general shield case is used, the maximum peak A of EMI noise indicates 57.65 dB in a frequency of 30-230 MHz, whereas, with reference to FIG. 15, the maximum peak B of EMI noise indicates 38.15 dB in a frequency of 30-230 MHz.

In the first embodiment of the present invention, the shield case, that accommodates the space between the chassis base and the circuit board and the entire outer wall of the circuit board, reduces EMI noise by 19.5 dB, as compared to the general shield case which encloses only a space where the circuit elements are mounted on the circuit board.

Hereinafter, the reference numerals that are the same as those of the drawings described above denote the same or substantially similar elements having the same functions.

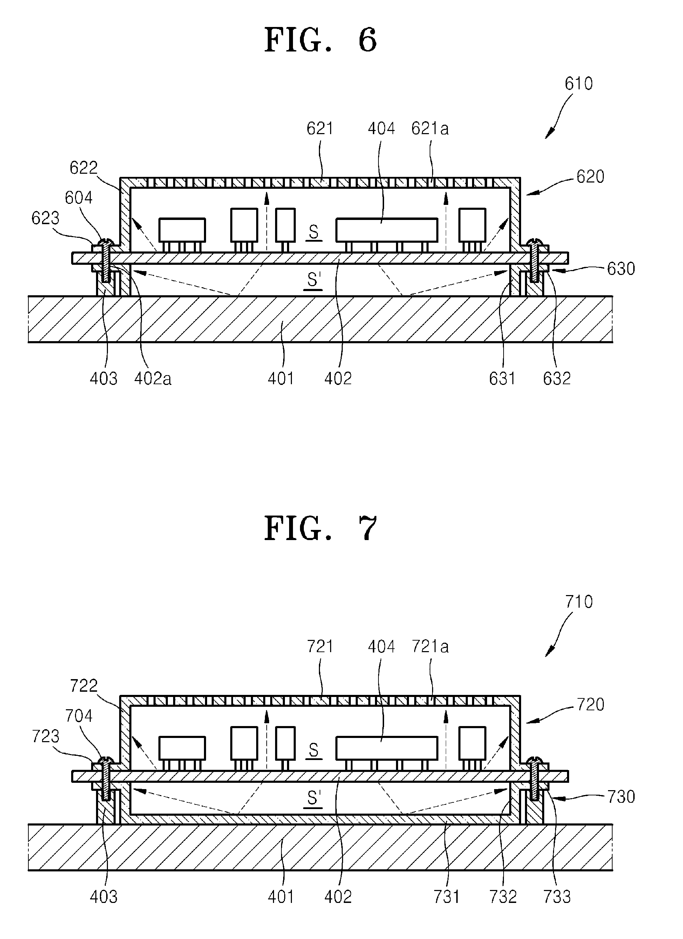

Referring to FIG. 6, the circuit board 402 is attached to a surface of the chassis base 401 and includes a plurality of circuit elements 404 mounted on the surface that is opposite the surface facing the chassis base 401. As shown in the figure, the portions of the circuit board 402 above and below where the circuit elements 404 are mounted are shielded from the outside environment by a shield case 610. The shield case 610 includes a first shield case 620 installed on the circuit board 402 and a second shield case 630 installed between the chassis base 401 and the circuit board 402.
Similarly to previously described embodiments, the first shield case 620 includes a ceiling 621 spaced from the circuit board 402, a sidewall 622 extending downward from the ceiling 621, and the first flange 623 extending outwardly from the first sidewall 622.

The ceiling 621 substantially corresponds to a shape of the circuit board 402. The ceiling 621 may include a plurality of heat radiation holes 621a through which heat generated from the circuit elements 404 is emitted. The first shield case 620 is dimensioned to form a first space S to accommodate the circuit board 402 and the circuit elements 404.

The first sidewall member 622 may have a height sufficient to accommodate the circuit board 402, on which the circuit elements 404 are mounted, by forming the first space S.

The first flange member 623 is bent in an outward direction from the edge of the first sidewall member 622. The first flange member 623 may be extended as a whole along four sides of the first sidewall member 622. However, some parts from among the four sides of the first sidewall member 622 may also be bent.

The second shield case 630 includes a sidewall 631 between the chassis base 401 and the circuit board 402, and a second flange 632 extending outwardly from the sidewall 631. In one exemplary embodiment, the sidewall 631 forms a substantially square band to surround the circuit board 402 and is between the chassis base 401 and the circuit board 402 to create a second space S' therein. The height of the sidewall 631 substantially corresponds to the distance between the chassis base 401 and the circuit board 402.

As such, the second sidewall member 631 is installed between the chassis base 401 and the circuit board 402 so as to shield the second space S' formed therein from the outside environment.

The second flange 632 extends outwardly from a top edge of the second sidewall 631. However, the present invention is not limited thereto and the second flange 632 may extend outwardly from a bottom edge of the sidewall 631 that corresponds to the chassis base 401 or may extend inwardly from the edge of the second sidewall 631. The flange 623 and/or the flange 632 are grounded by being electrically connected to a ground line on the circuit board 402.

The shield case 610 includes the second shield case 630 outside of the chassis base 401. The circuit board 402 is on the second shield case 630. The first shield case 620 is on the circuit board 402 on which the circuit elements 404 are mounted. Accordingly, the second shield case 630 is between the chassis base 401 and the circuit board 402, and the first shield case 620 is on the circuit board 402.

As described above, after the first shield case 620 and the second shield case 630 are located on the circuit board 402, the flange 623 and the flange 632 are aligned with the boss 403. A fastener, such as screw 604, is inserted through a boss hole 402a to attached the first shield case 620 and the second shield case 630. Accordingly, the first space S is shielded by the first shield case 620 and the second space S' is shielded by the second shield case 630. As such, EMI noise radiated from the plurality of circuit elements 404 can be reduced or minimized by the first shield case 620 and the second shield case 630.

Referring to FIG. 7, the circuit board 402 is disposed on one surface of the chassis base 401 and the plurality of circuit elements 404 is mounted on the circuit board 402. The shield case 710 is installed above and below the circuit board 402 and includes a first shield case 720 installed on the circuit board 402 and a second shield case 730 installed between the chassis base 401 and the circuit board 402.

The first shield case 720 includes a ceiling 721 spaced from the circuit elements 404 and having a plurality of heat radiation holes 721a, a first sidewall 722 extending downwards from the ceiling 721, and a first flange 723 extending outwardly direction from a bottom edge of the first sidewall 722. The ceiling 721 and the first sidewall 722 form a first space S to enclose the circuit board 402 and the circuit elements 404.

The second shield case 730 includes a bottom unit 731 contacting the outer surface of the chassis base 401, a second sidewall 732 extending upwards from the bottom unit 731, and a second flange 733 extending outwardly direction from the second sidewall 732. The bottom unit 731 and the second sidewall 732 are combined to form the second space S' to shield the chassis base 401 and the circuit board 402 from the outside environment.

The first flange 723 and/or the second flange 733 are grounded by being electrically connected to a ground line on the circuit board 402. Additionally, the first flange 723 and the second flange 733 are combined by a screw 704 passing through the boss 403 projected from the chassis base 401 at the edge of the circuit board 402 to attach the first shield case 720 and the second shield case 730.

Accordingly, the first space S proximate the circuit board 402 is shielded by the first shield case 720 and the second space S' between the chassis base 401 and the circuit board 402 is shielded by the second shield case 730.

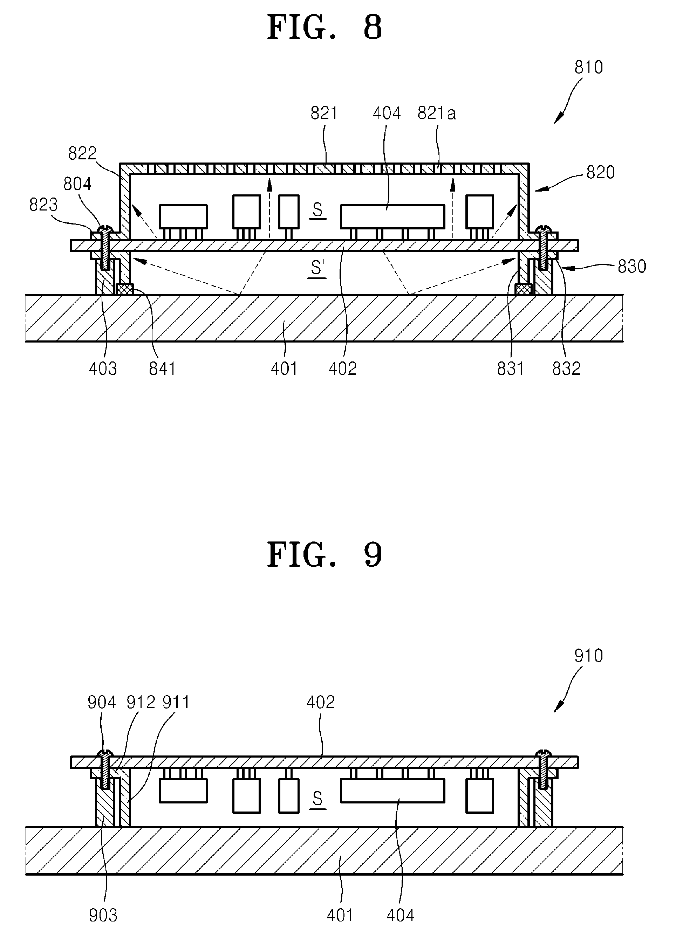

Referring to FIG. 8, the circuit board 402 is disposed on one surface of the chassis base 401 and a shield case 810 is installed above and below the circuit board 402. The shield case 810 includes a first shield case 820 installed on the circuit board 402 and a second shield case 830 installed between the chassis base 401 and the circuit board 402. The first shield case 820 includes a first sidewall 822 extending downwards from a ceiling 821 to form a first space S for accommodating the circuit board 402 and a first flange 823 extending outwardly from the first sidewall 822. The ceiling 821 may include a plurality of heat radiation holes 821a.

The second shield case 830 includes a second sidewall 831 and a second flange 832 extending outwardly from the second sidewall 831 to form a second space S' between the chassis base 401 and the circuit board 402.

The first flange 823 and the second flange 832 are aligned at the edge of the circuit board 402 and attached by a screw 804 penetrating the first flange 823, the circuit board 402, the second flange 832 and a boss 403. An EMI sponge 841 is between the chassis base 401 and the second sidewall 831 along a region where the second sidewall 831 contacts the outer surface of the chassis base 401. Accordingly, EMI noise radiating from the plurality of circuit elements 404 is reduced by the first and second shield cases 820, 830 and vibration can be absorbed by the EMI sponge 841. Accordingly, when EMI noise is radiated from the plurality of circuit elements 404, EMI noise can be reduced by the first shield case 820 and the second shield case 830 and generated vibrations can be absorbed by the EMI sponge 841.

Referring to FIG. 9, the circuit board 402 is disposed on the chassis base 401 and a plurality of circuit elements 404 are mounted on the circuit board 402 between the chassis base 401 and the circuit board 402. A space S is created between the chassis base 401 and the circuit board 402 by the shield case 910. The shield case 910 includes a sidewall 911 surrounding the circuit board 402 and a flange 912 extending outwardly from an edge of the sidewall 911. The sidewall 911 is dimensioned to create the space S between the chassis base 401 and the circuit board 402 for shielding those components from the atmosphere. The flange 912 is attached to a boss 903 protruding from the chassis base 401 by a screw 904.

The sidewall member 911 has a height which enables the space S disposed between the chassis base 401 and the circuit board 402 to be shielded from the outside and the flange member 912 is combined with a boss 903 projected from the chassis base 401 by a screw 904 so as to fix the position of the shield case 910.

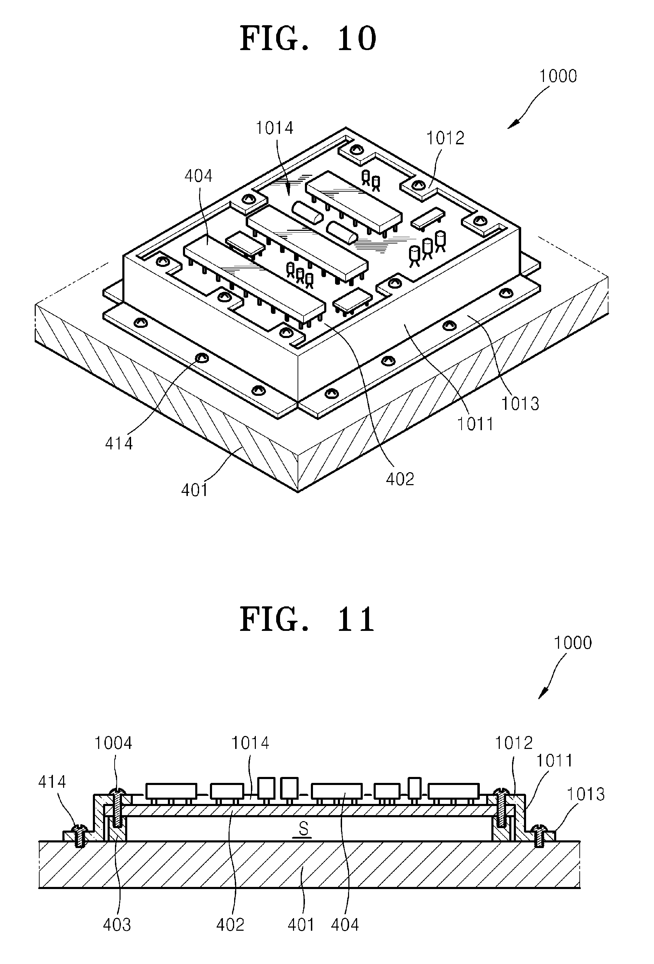

Referring to FIGS. 10 and 11, the circuit board 402 is spaced from the chassis base 401 and has a plurality of circuit elements 404 mounted on an upper surface. A space S is formed between the chassis base 401 and the circuit board 402 and is shielded by the shield case 1000. The shield case 1000 includes a sidewall 1011 wherein the sidewall member 1011 shields the space S disposed between the chassis base 401 and the circuit board 402, extending upward from the chassis base, a plurality of tabs 1012 extending from a top edge of the sidewall 1011, and a flange 1013 extending outwardly from a bottom edge of the sidewall 1011.

In one exemplary embodiment, the sidewall 1011 forms substantially a square band to surround the circuit board 402. The height of the sidewall 1011 is greater than a distance between the chassis base 401 and the upper surface of the circuit board 402. Accordingly, the sidewall 1011 shields the space S between the chassis base 401 and the circuit board 402.

The tab 1012 extends inwardly toward the circuit board 402 from one edge of the sidewall 1011 and is substantially square-shaped. The tab 1012 may be grounded by being electrically connected to a ground line on the circuit board 402. The flange 1013 extends outwardly from a bottom edge of the sidewall 1011, but the flange may also extend inwardly.

The flange member 1013 can be bent as a whole from the other edge of the sidewall member 1011, any one part of the flange member 1013 can be bent.

The shield case has a single heat radiation hole 1014 allowing for the circuit board and circuit elements to be exposed. As such, when the circuit board 402 is a power supply board that releases a large amount of heat, such as a switching mode power supply (SMPS), the large amount of heat can be quickly dissipated.

The shield case 1000 can accommodate the circuit board 402 and a space S disposed between the chassis base 401 and the circuit board 402 can be sealed. In addition, since the tabs 1012 are formed along the edge of the circuit board 402, the shield case 1000 can be attached by a screw 1004, or other suitable fastener passing through the boss 403 projected from the chassis base 401. Similarly, the flange 1013 may be attached to the outer surface of the chassis base 401 by other suitable methods, such as riveting, screwing, laser welding, and welding.

Accordingly, EMI noise between the chassis base 401 and the circuit board 402 is shielded by the shield case 1000. In addition, since the tabs 1012 are grounded by being electrically connected to a ground line and the flange 1013 is grounded to the outer surface of the chassis base 401, the shield case 1000 can reduce induced current generated from the circuit elements 404. Moreover, heat generated from the circuit elements 404 of the circuit board 402, for example, a switching mode power supply, can be immediately emitted through the heat radiation hole 1014.

Referring to FIG. 12, a space S between the chassis base 401 and the circuit board 402 is shielded by a shield case 1200. The shield case 1200 includes a sidewall 1211, and a flange member 1213, wherein the sidewall member 1211 shields the space S disposed between the chassis base 401 and the circuit board 402, the plurality of projecting parts 1212 is projected from one edge of the sidewall member 1211 and combined with the edge of the circuit board 402 by using a screw, a plurality of tabs 1212 extending toward the circuit board 402 and connected thereto, and a flange 1213 extending outwardly from a bottom edge of the sidewall 1211 and attached to the chassis base 401.

A heat radiation hole 1214 centrally located between the sidewalls 1211 allows exposure of the circuit board 402 and circuit elements 404. As such, a heat emission path is created for a power supply board that generates a large amount of heat, such as a switching mode power supply.

A plurality of clips 1219 are located along the circumference of the circuit board 402, and may include metal, composites, or non-metals having a suitable elasticity. The flange 1213 may form an interference fit with the clip members 1219 to attach the shield case 1200 onto the chassis base.

Accordingly, the shield case 1200 shields the space S disposed between the chassis base 401 and the circuit board 402, the flange member 1213 is inserted into the clip members 1219 by force so as to be fixed, and the position of the shield case 1200 is fixed by the elasticity of the clip members 1219.

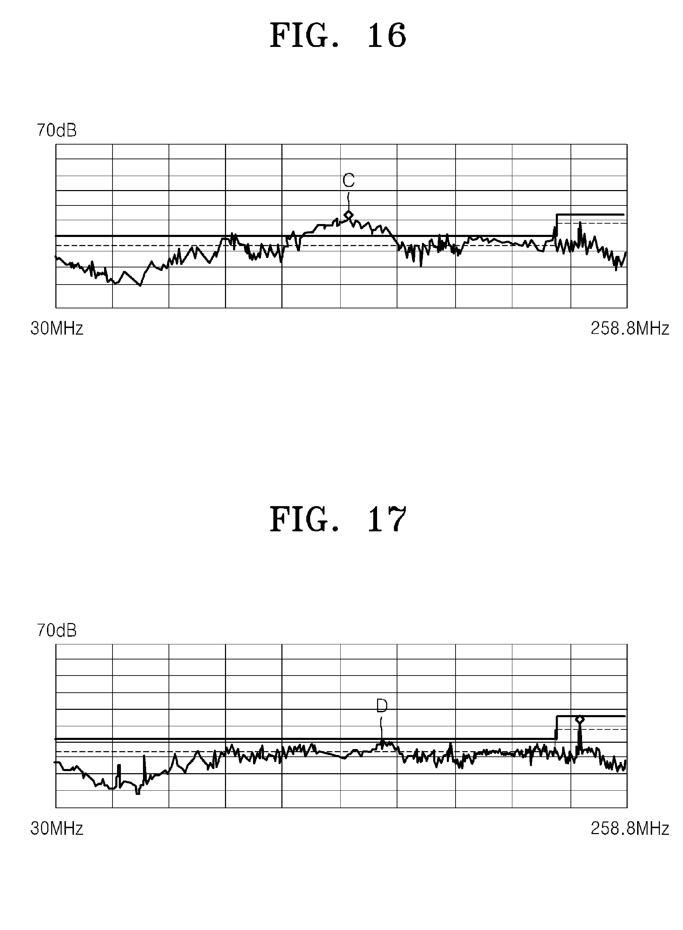

EMI noise as a result of an experiment is illustrated in FIGS. 16 and 17. FIG. 16 shows the EMI noise results from a circuit board not shielded by an exemplary shield case of the present invention. FIG. 17 shows the EMI noise results from when an exemplary shield case according to the sixth embodiment of the present invention is used. The X-axis indicates a frequency in a range of 0 to 258.8 MHz and the Y-axis indicates a decibel range of 0-70 dB. Referring to FIG. 16, when the shield case is not installed, the maximum peak C of EMI noise indicates 45.63 dB in a frequency of 30-258.8 MHZ, whereas the maximum peak B of EMI noise indicates 40.19 dB in a frequency of 30-258.8 MHZ in FIG. 17.

As illustrated in the sixth embodiment of the present invention, the shield case including the space between the chassis base and the circuit board shields the power supply board reduces EMI noise by 5.44 dB, as compared to when the shield case is not installed.

As described above, the chassis base assembly including exemplary shield cases of the present invention shield the circuit elements on the circuit board and a space between the chassis base and the circuit board to significantly reduce EMI noise. While the present invention has been described in connection with certain exemplary embodiments, it is to be understood that the invention is not limited to the disclosed embodiments, but, on the contrary, is intended to cover various modifications and equivalent arrangements included within the scope of the appended claims.

## Claims

1. A chassis base assembly for a display device, comprising:
a chassis base (401);
a circuit board (402) mounted to the chassis base to form a space between the circuit board and the chassis base; and
a shield case (410, 610, 710, 810, 910, 1000, 1200, 1300) surrounding the space between the chassis base and the circuit board.

2. The chassis base assembly of claim 1, wherein the circuit board has a plurality of circuit elements disposed thereon, the shield case (410, 610, 710, 810, 1300) being arranged to cover a surface of the circuit board on which the circuit elements are disposed.

3. The chassis base assembly of claim 1 or 2, wherein the shield case surrounds the circuit board.

4. The chassis base assembly of any one of the preceding claims, further comprising a flange (413) extending from a bottom edge of a side wall (412) of the shield case, the flange being attachable to the chassis base by a fastener (414).

5. The chassis base assembly of any one of claims 1 to 3, wherein a side wall (1312) of the shield case (1300) includes a groove (1313), the side wall comprising a tab (1314) bent into the groove, and wherein the tab is combined with the circuit board by a fastener (409).

6. The chassis base assembly of any one of the preceding claims, wherein a ceiling of the shield case comprises a plurality of heat radiation holes (411a, 1315).

7. The chassis base assembly of claim 1, wherein the shield case (610, 710, 810) comprises a first shield case (620, 720, 820) on a surface of the circuit board on which a plurality of circuit elements are disposed and a second shield case (630, 730, 830) between the chassis base and the circuit board.

8. The chassis base assembly of claim 7, wherein the second shield case comprises a side wall (631, 831) surrounding the first space between the chassis base and the circuit board or wherein the second shield case comprises a bottom unit (731) contacting the chassis base and a sidewall (732) extending toward the circuit board from the bottom unit to enclose the space between the chassis base and the circuit board.

9. The chassis base assembly of claim 7 or 8, wherein the first shield case (620, 720, 820) and the second shield case (630, 730, 830) are fastened together with the circuit board therebetween.

10. The chassis base assembly of any one of claims 7 to 9, further comprising an EMI sponge (841) between the chassis base and the second shield case (830).

11. The chassis base assembly of any one of claims 7 to 10, wherein the first shield case (620, 720, 820) comprises a plurality of heat radiation holes.

12. The chassis base assembly of claim 1, further comprising
a plurality of circuit elements mounted on the circuit board and located between the chassis base and the circuit board.

13. The chassis base assembly of claim 1, wherein the shield case (1000, 1200, 1300) comprises a plurality of tabs (1012) attached to the circuit board.

14. The chassis base assembly of claim 13, wherein the shield case further comprises a side wall (1011, 1211, 1312) surrounding the space between the circuit board and the chassis base; and wherein the plurality of tabs are attached by a fastener to a surface of the circuit board on which circuit elements are mounted.

15. The chassis base assembly of claim 14, further comprising a single heat radiation hole (1014, 1214) exposing the plurality of circuit elements.

16. The chassis base assembly of claim 14 or 15, further comprising comprises a flange (1013) extending from an edge of the side wall and attached to the chassis base by a fastener (414), or further comprising a flange (1213) extending from the side wall and engaging a clip (1219) on the chassis base to secure the shield case by a force fit.

17. A display device (100) comprising:
a panel assembly (103); and
a chassis base assembly according to any one of the preceding claims attached to the panel assembly.
